# EUROPEAN PATENT APPLICATION

(11) **EP 2 482 328 A2**
(43) Date of publication of application: **01.08.2012**
(21) Application number: 12152870.7
(22) Date of filing: 27.01.2012
(51) Int. Cl.: H01L 31/0224, H01L 31/18

(54) **Fabrication method for local back contact photovoltaic cells**

(30) Priority: 31.01.2011 US 201161462350 P
(71) Applicant: IMEC, 3001 Leuven (BE); Katholieke Universiteit Leuven K.U. Leuven R&D, 3000 Leuven (BE)
(72) Inventor: Vermang, Bart, 3000 Leuven (BE); Goverde, Hans, 5616 CB Eindhoven (NL)
(74) Representative: Bird Goën & Co

(57) **Abstract**

A method is disclosed for fabricating a photovoltaic cell comprising local back contacts, comprising:
- providing a silicon substrate;
- depositing a surface passivation layer at a rear side of the silicon substrate;
- forming delaminated regions at an interface between the surface passivation layer and the silicon substrate;
- depositing a metal layer on the surface passivation layer; and performing a metal firing step; use of the method for forming local back contacts, and photovoltaic device associated to the method.

## Description

### Technical field of the disclosure

This disclosure relates to the field of photovoltaic cells. More in particular it relates to a method of manufacturing photovoltaic cells with local back contacts and to photovoltaic cells thus obtained.

### Background of the invention

Advanced device structures have been developed for crystalline silicon photovoltaic cells with local back contacts, such as for example PERC (passivated emitter and rear cell) and PERL (passivated emitter rear locally diffused cell) structures. Such advanced device structures lead to higher energy conversion efficiencies but require more process steps and thus result in a higher fabrication cost as compared to less advanced structures.

There is a need for a reduction of the cost per Watt peak of crystalline silicon photovoltaic cells, for example by reducing the fabrication cost and at the same maintaining good energy conversion efficiencies.

### Summary of the disclosure

A first inventive aspect relates to a method for fabricating silicon photovoltaic cells with local back contacts, wherein the number of process steps is reduced as compared to prior art fabrication methods and thus the manufacturing cost is reduced, and wherein the method allows fabricating local back contact cells with a good open-circuit voltage and a good short-circuit current, resulting in good energy conversion efficiencies.

A method is disclosed for fabricating a photovoltaic cell comprising local back contacts, comprising:
- providing a silicon substrate;
- depositing a surface passivation layer at a rear side of the silicon substrate;
- forming delaminated regions as for instance bubbles at an interface between the surface passivation layer and the silicon substrate;
- depositing a metal layer on the surface passivation layer; and performing a metal firing step.

A "delaminated region" refers to a region which is delaminated, as for instance a bubble or blister. For the purpose of the present description, the terms "bubble" and "blister" are used as synonyms.

Thereby a conductive path is provided between the metal layer and the silicon substrate at the location of the delaminated regions, resulting in back contacts for the photovoltaic cell or device.

Advantageously, forming delaminated regions at an interface between the surface passivation layer and the silicon substrate comprises:
a. cleaning the silicon substrate using a hydrophobic cleaning method;
b. depositing the surface passivation layer at a rear side of the silicon substrate after hydrophobic cleaning;
c. performing a thermal treatment.

One inventive aspect relates to a method for fabricating silicon photovoltaic cells with local back contacts, wherein the method comprises: providing a silicon substrate; cleaning the silicon substrate using a hydrophobic cleaning method; after hydrophobic cleaning, depositing a surface passivation layer at a rear side of the silicon substrate, the surface passivation layer preferably having a thickness of at least about 30 nm; performing a thermal treatment at a temperature preferably in the range between about 400°C and 600°C, thereby forming delaminated regions at an interface between the surface passivation layer and the silicon substrate; depositing a metal layer on the surface passivation layer; and performing a metal firing step. During the metal firing step, local back contacts are formed at the location of the delaminated regions. Thus, local back contacts are formed without the need for making openings in the surface passivation layer before depositing the metal layer. It is believed that, according to certain embodiments, the contacts may be formed due to microscopic cracks in the delaminated regions, as for instance in the bubbles or blisters, which allow the penetration of the metal within the blister and towards the silicon substrate.

In one aspect, a hydrophobic cleaning method is a cleaning method leaving a hydrophobic surface after cleaning. For example, a hydrophobic cleaning method can comprise performing a dip in diluted HF as a last step.

The surface passivation layer can be a single layer or a stack of layers comprising at least a first layer (deposited on the silicon substrate) and a second layer (deposited on the first layer). In embodiments wherein the surface passivation layer is a single layer, it can for example be an Al₂O₃ layer having a thickness of at least about 30 nm. In embodiments wherein the surface passivation layer is a stack of layers, the first layer can for example be an Al₂O₃ layer, e.g. with a thickness in the range between about 2 nm and 30 nm, e.g. about between 5 nm and 15 nm, and the second layer can for example be a SiNₓ layer and/or a SiOₓ layer, e.g. with a thickness in the range between about 70 nm and 300 nm, e.g. between about 100 nm and 200 nm. The Al₂O₃ layer can for example be provided by thermal ALD (atomic layer deposition), plasma enhanced ALD, plasma enhanced CVD (chemical vapour deposition), or by any other suitable method known by a person skilled in the art. In certain embodiments, a thermal ALD Al₂O₃ layer is preferably deposited at a temperature lower than about 250°C, such as e.g. between about 200°C and 250°C. The second layer can be deposited by CVD, preferably at a temperature in the range between about 400°C and 600°C, thereby at the same time performing the thermal treatment and avoiding the need for a separate thermal treatment. The metal layer deposited on the surface passivation layer can for example comprise Al. The metal firing step induces the formation of local contacts at the location of delaminated regions. The metal firing step is preferably performed at a temperature larger than about 835°C, e.g. at a temperature in the range between about 835°C and 950°C.

According to embodiments of the present invention, the method can further comprise a step of introducing surface features on the rear side of the silicon substrate in order to control position and/or density of the formation of delaminated regions or blisters.

According to embodiments of the present invention, the method further comprises performing an additional anneal step after depositing the first layer and before depositing the second layer, the additional anneal step being adapted for avoiding the formation of a second type of delaminated regions as for instance bubbles when firing the metal. Preferably, the additional anneal step is performed at a temperature above 600 °C, more preferably at a temperature within the range of 600 °C to 900 °C, more preferably in the range of 600 °C to 800 °C. The additional anneal step can have a duration within the range of 20 minutes to 60 minutes, for instance typically 30 minutes. The additional anneal step can for example be done in forming gas or in an inert atmosphere such as a nitrogen atmosphere.

It is an advantage of a method according to one inventive aspect that the metal firing step leads to the formation of local rear side contacts without the need for providing openings in the surface passivation layer before providing the metal layer. Thus the number of process steps is reduced and the manufacturing throughput is increased as compared to prior art fabrication processes for photovoltaic cells with local back contacts.

It is an advantage of a method according to one aspect that the Al₂O₃ layer can be deposited at a low temperature (e.g. 200°C), leading to a better surface passivation quality as compared to Al₂O₃ layers deposited at higher temperatures.

A second inventive aspect relates to the use of the method according to the first aspect for forming local back contacts of the photovoltaic cells at the location of the delaminated regions as for instance bubbles.

A third inventive aspect relates to a photovoltaic device having a rear surface and a front surface, comprising
a. a silicon substrate;
b. a surface passivation layer at a rear side of the silicon substrate;
c. local back contacts;
wherein the local back contacts are randomly distributed on the rear surface of the photovoltaic device.

The fact that the local back contacts are randomly distributed means that any predetermined position of any of the back contacts, or predetermined regularity or periodicity in the positions of the back contacts is absent.

According to preferred embodiments, the surface passivation layer comprises delaminated regions at positions corresponding to the local back contacts. In another view, the local back contacts can comprise or correspond to delaminated regions.

According to preferred embodiments, the surface passivation layer has a thickness of at least 30 nm.

According to preferred embodiments, the surface passivation layer comprises a first layer comprising Al₂O₃, with a thickness in the range between about 2 nm and 30 nm, and a second layer comprising a SiNₓ layer and/or a SiOₓ layer, with a thickness in the range between about 70 nm and 300 nm.

Certain objects and advantages of certain inventive aspects have been described herein above. Of course, it is to be understood that not necessarily all such objects or advantages may be achieved in accordance with any particular embodiment of the disclosure. Thus, for example those skilled in the art will recognize that the disclosure may be embodied or carried out in a manner that achieves or optimizes one advantage or group of advantages as taught herein without necessarily achieving other objects or advantages as may be taught or suggested herein. Further, it is understood that this summary is merely an example and is not intended to limit the scope of the disclosure. The disclosure, both as to organization and method of operation, together with features and advantages thereof, may best be understood by reference to the following detailed description when read in conjunction with the accompanying drawings.

### Brief description of the drawings

Figure 1 is a microscope picture of a thermal ALD Al₂O₃ layer capped with PECVD SiNₓ.
Figure 2 is SEM picture (cross section) of a partially delaminated ALD Al₂O₃ / PECVD SiNₓ stack.
Figure 3 shows optical microscope pictures of CZ Si substrates at different stages: Figure 3(a) after ALD deposition of 5 nm Al₂O₃; Figure 3(b) after ALD deposition of 5 nm Al₂O₃ and annealing in a nitrogen atmosphere at 550°C; and Figure 3(c) after ALD deposition of 5 nm Al₂O₃, annealing in a nitrogen atmosphere at 550°C and SiNₓ deposition.
Figure 4 shows optical microscope pictures of CZ Si substrates at different stages: Figure 4(a) after ALD deposition of 30 nm Al₂O₃; Figure 4(b) after ALD deposition of 30 nm Al₂O₃ and annealing in Forming Gas at 350°C; and Figure 4(c) after ALD deposition of 30 nm Al₂O₃, annealing in a Forming Gas at 350°C and SiNₓ deposition.
Figure 5 shows optical microscope pictures of CZ Si substrates at different stages: Figure 5(a) after ALD deposition of 30 nm Al₂O₃ and annealing in nitrogen at 350°C; and Figure 5(b) after ALD deposition of 30 nm Al₂O₃, annealing in nitrogen at 350°C and SiNₓ deposition.
Figure 6 shows optical microscope pictures of CZ Si substrates at different stages: Figure 6(a) after ALD deposition of 30 nm Al₂O₃ and annealing in nitrogen at 550°C; and Figure 6(b) after ALD deposition of 30 nm Al₂O₃, annealing in nitrogen at 550°C and SiNₓ deposition. Figure 7 is SEM picture (cross section) of a local contact (with back surface field) formed after firing an A1 metal layer on top of a delaminated region. Figure 7 shows a local Back Surface Field (BSF) formed at the location of a blister during co-firing.
Figure 8 shows a comparison chart between the process flow according to embodiments of the present invention and alternative, state of the art process flows.
Figure 9 shows (a) SEM tilted top-view and (b) cross-section images of a blistered ALD Al2O3 / PECVD SiNx layer on a mirror-polished c-Si substrate. (c) and (d) are optical microscopy top-view pictures of an ALD Al2O3 / PECVD SiNx layer grown on a rough c-Si surface, the pre-ALD deposition clean was hydrophilic or hydrophobic, respectively.
Figure 10 is a schematic representation of semiconductor-metal contact generation by means of firing a blistered passivation layer covered by Al.
Figure 11(a) Average blistering radius for a stack of 5, 10 or 30 nm of ALD Al2O3 and PECVD SiNx before and after co-firing. The pre-ALD wafer cleaning was hydrophilic (Si-OH) or hydrophobic (Si-H).
Figure 11 (b) and (c) depict the average Jsc, Voc, FF and Eta for random A1 BSF Si solar cells passivated at the rear by the same A12O3 / SiNx layers. In all cases the peak firing temperature was 865 °C.
Figure 12 shows a LBIC mapping of a random A1 BSF solar cell part, clearly showing the random metal-semiconductor contacts at the rear (20 µm as resolution).
Figure 13 (a), (b), (c) and (d) show respectively the average Jsc, Voc, FF and Eta for A12O3 / SiNx rear passivated random A1 BSF Si solar cells as a function of peak firing temperature. The pre- Al2O3 cleaning was hydrophobic and the A12O3 thickness 5, 10 or 30 nm. Also the average cell characteristics for the reference full A1 BSF cells are indicated.
Figure 14 illustrates the process flows of (a) a state of the art process wherein contacts at the rear surface are opened by means of laser ablation and (b) a process flow according to embodiments of the present invention wherein contact are formed by means of blisters in the passivation layer.
Figures 15 (a) and (b) illustrate a process flow according to embodiments of the present invention wherein contacts are formed by means of blisters in the passivation layer. Flow (a) comprises images of real samples, while flow (b) is a schematic representation of the same flow.

In the different drawings, the same reference signs refer to the same or analogous elements.

### Description of illustrative embodiments

In the following detailed description, numerous specific details are set forth in order to provide a thorough understanding of the disclosure and how it may be practiced in particular embodiments. However, it will be understood that the present disclosure may be practiced without these specific details. In other instances, well-known methods, procedures and techniques have not been described in detail, so as not to obscure the present disclosure. While the present disclosure will be described with respect to particular embodiments and with reference to certain drawings, the disclosure is not limited hereto. The drawings included and described herein are schematic and are not limiting the scope of the disclosure. It is also noted that in the drawings, the size of some elements may be exaggerated and, therefore, not drawn to scale for illustrative purposes.

Furthermore, the terms first, second, third and the like in the description, are used for distinguishing between similar elements and not necessarily for describing a sequence, either temporally, spatially, in ranking or in any other manner. It is to be understood that the terms so used are interchangeable under appropriate circumstances and that the embodiments of the disclosure described herein are capable of operation in other sequences than described or illustrated herein.

Moreover, the terms top, bottom, over, under and the like in the description are used for descriptive purposes and not necessarily for describing relative positions. It is to be understood that the terms so used are interchangeable under appropriate circumstances and that the embodiments of the disclosure described herein are capable of operation in other orientations than described or illustrated herein.

It is to be noticed that the term "comprising" should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B.

In certain embodiments, the front surface or front side of a photovoltaic cell or of a substrate is the surface or side adapted for being oriented towards a light source and thus for receiving illumination. The back surface, rear surface, back side or rear side of a photovoltaic cell or of a substrate is the surface or side opposite to the front surface or side.

One embodiment relates to a method for the fabrication of photovoltaic cells with local back contacts, wherein the method comprises: providing a silicon substrate; cleaning the silicon substrate using a hydrophobic cleaning method; after hydrophobic cleaning, providing at a rear side of the silicon substrate a surface passivation layer, the surface passivation layer having a thickness of at least about 30 nm, for example a thickness in the range between about 30 nm and 150 nm; and performing a thermal treatment at a temperature in the range between about 400°C and 600°C. This results in the formation of bubbles or delaminated regions at the interface between the semiconductor substrate and the surface passivation layer. The surface passivation layer can comprise a single layer or it can comprise a stack of at least a first layer and a second layer. In embodiments wherein the surface passivation layer comprises at least a first layer and a second layer, the deposition of the second layer can also have the function of the thermal treatment. The thickness of the surface passivation layer can be selected for providing a good back reflection in addition to providing a good rear surface passivation quality. The method further comprises providing a metal layer, e.g. an A1 layer, covering the surface passivation layer at the rear side and performing a metal firing step, thereby forming rear contacts and rear BSF regions in the delaminated regions. Providing the metal layer can comprise screen printing, sputtering, evaporation or any other suitable method known to a person skilled in the art. Performing the metal firing step is preferably done at a temperature higher than about 835°C, e.g. at a temperature in the range between about 835°C and 950°, for example between about 850°C and 900°C.

In certain embodiments, the surface passivation layer can for example comprise an Al₂O₃ layer. In embodiments wherein the surface passivation layer is a single layer, the thickness of the Al₂O₃ layer is at least about 30 nm. In embodiments wherein the surface passivation layer is a stack of layers, the Al₂O₃ layer is provided as a first layer on the rear side of the silicon substrate and the second layer is provided on the first layer. The total thickness of the first layer and the second layer is preferably at least about 100 nm.

The Al₂O₃ layer can for example be provided by means of ALD (atomic layer deposition), e.g. thermal ALD or plasma enhanced ALD. However, the present disclosure is not limited thereto and other suitable methods known by a person skilled in the art can be used. Preferably the ALD Al₂O₃ layer is deposited at a temperature lower than about 250°C, e.g. using H₂O and TMA as precursors. The second layer can for example be a SiNₓ layer or a SiOₓ layer or any other suitable layer known by a person skilled in the art. The second layer can for example be deposited by a Chemical Vapor Deposition method, preferably at a temperature in the range between about 400°C and 600°C.

It is an advantage of a method according to one embodiment as compared to prior art fabrication methods for photovoltaic cells with local back contacts that the need for creating openings in the rear surface passivation stack before providing the rear metal layer for enabling the formation of local metal contacts can be avoided. Instead, during the metal firing step, local contacts are formed in the delaminated regions.

It has been shown that Al₂O₃ layers, e.g. deposited by means of ALD techniques, provide a very good passivation for p-type silicon. This excellent passivation quality is related to chemical passivation and field effect passivation. The best ALD Al₂O₃ passivation quality is obtained at low deposition temperatures (e.g. at 200°C).

Layers deposited at this low temperature also reveal 'blisters' or 'bubbles', caused by partial delamination if a critical thickness of the passivation layer (e.g. about 30 nm for an Al₂O₃ layer, e.g. about 100 nm for a stack comprising an Al₂O₃ layer and a SiNₓ layer) and a critical temperature (e.g. about 400°C to 600°C) are reached. Partial delamination may for example be related to stress built up in the Al₂O₃ layer or may be related to hydrogen release in the Al₂O₃ layer upon a thermal treatment above the critical temperature. In a method according to one embodiment, this partially delaminated passivation layer is used as rear surface passivation for PERC-type solar cells. The bubbles become local point contacts after firing of the rear metal. In addition, firing of the rear metal results in the formation of a local Back Surface Field.

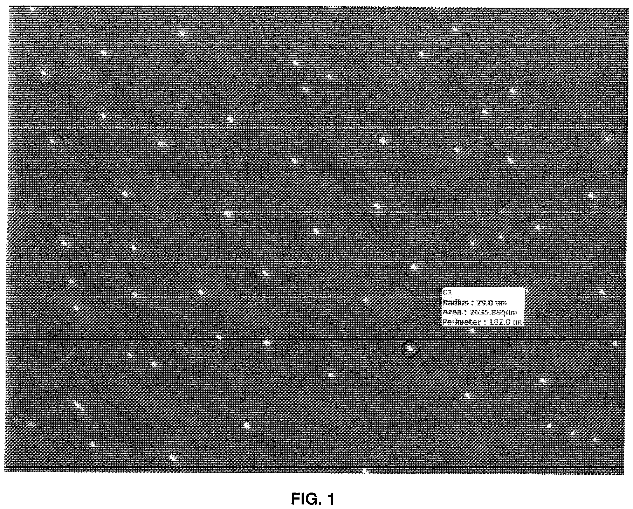

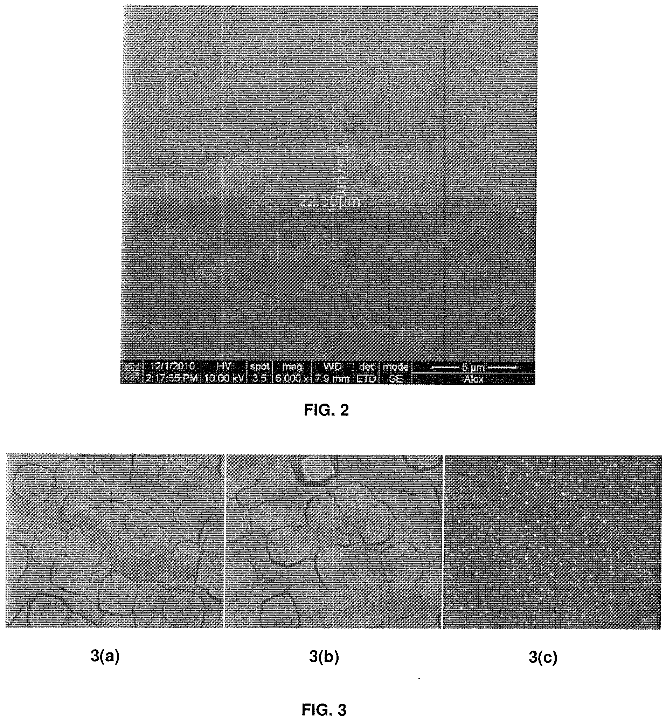

Figure 1 is a microscope picture (top view) of a surface passivation layer comprising an about 30 nm thick thermal ALD Al₂O₃ layer capped with a 100 nm thick PECVD SiNₓ layer, deposited on a hydrophobically cleaned mirror-polished silicon substrate. The thermal ALD Al₂O₃ layer was deposited at 200°C using H₂O and TMA as precursors. Figure 2 is SEM picture (cross section) of the partially delaminated ALD Al₂O₃ / PECVD SiNₓ stack of Figure 1. It can be seen that the partial delamination results in the formation of a bubble, in the example shown having a diameter of 22.6 micrometer.

Figure 3 shows optical microscope pictures of CZ Si substrates at different stages: Figure 3(a) after ALD deposition of 5 nm Al₂O₃; Figure 3(b) after ALD deposition of 5 nm Al₂O₃ and annealing in a nitrogen atmosphere at 550°C; and Figure 3(c) after ALD deposition of 5 nm Al₂O₃, annealing in a nitrogen atmosphere at 550°C and SiNₓ deposition at 420°C (SiNₓ layer thickness 200 nm to 300 nm).

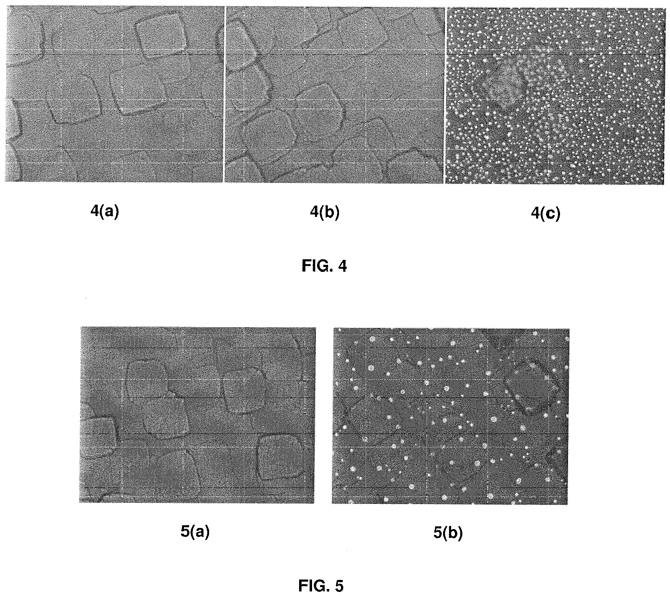

Figure 4 shows optical microscope pictures of CZ Si substrates at different stages: Figure 4(a) after ALD deposition of 30 nm Al₂O₃; Figure 4(b) after ALD deposition of 30 nm Al₂O₃ and annealing in Forming Gas at 350°C; and Figure 4(c) after ALD deposition of 30 nm Al₂O₃, annealing in a Forming Gas at 350°C and SiNₓ deposition at 420°C (SiNₓ layer thickness 200 nm to 300 nm).

Figure 5 shows optical microscope pictures of CZ Si substrates at different stages: Figure 5(a) after ALD deposition of 30 nm Al₂O₃ and annealing in nitrogen at 350°C; and Figure 5(b) after ALD deposition of 30 nm Al₂O₃, annealing in nitrogen at 350°C and SiNₓ deposition at 420°C (SiNₓ layer thickness 200 nm to 300 nm).

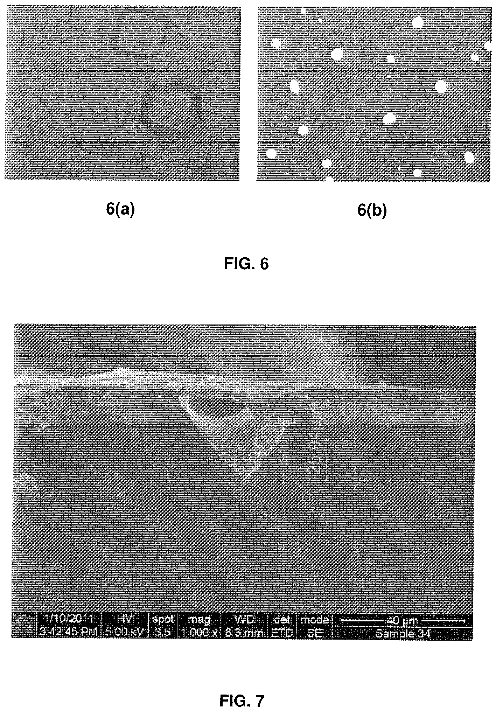

Figure 6 shows optical microscope pictures of CZ Si substrates at different stages: Figure 6(a) after ALD deposition of 30 nm Al₂O₃ and annealing in nitrogen at 550°C; and Figure 6(b) after ALD deposition of 30 nm Al₂O₃, annealing in nitrogen at 550°C and SiNₓ deposition at 420°C (SiNₓ layer thickness 200 nm to 300 nm).

For all the samples shown in Figure 3, Figure 4, Figure 5 and Figure 6 a hydrophobic cleaning (2% HF dip) of the silicon substrate was performed before Al₂O₃ deposition. From the results shown in Figure 3, Figure 4, Figure 5 and Figure 6, it can be concluded that the formation of bubbles or delaminated regions and the size and density of the delaminated regions are influenced by several parameters, such as the thickness of the Al₂O₃ layer, the ambient of the thermal treatment or annealing, the temperature of the thermal treatment, and the presence of a SiNₓ layer on top of the Al₂O₃ layer.

For example, comparing Figure 3(c) with Figure 6(b), there is a difference in the thickness of the Al₂O₃ layer, being 5 nm for the sample shown in Figure 3(c) and 30 nm for the sample shown in Figure 6(b). For the thicker Al₂O₃ layer the number of bubbles is smaller and they have a larger size. In Figure 6(a) it can be seen that for a 30 nm thick Al₂O₃ layer bubble formation starts after annealing and before SiNₓ deposition.

For example, comparing Figure 4(c) with Figure 5(b), there is a difference in the ambient of the thermal treatment, being Forming Gas for the sample shown in Figure 4(c) and nitrogen for the sample shown in Figure 5(b). The number of bubbles is smaller and they have a larger size when the thermal treatment is performed in nitrogen.

For example, comparing Figure 5(b) with Figure 6(b), there is a difference in the temperature of the thermal treatment, being 350°C for the sample shown in Figure 5(b) and 550°C for the sample shown in Figure 6(b). The number of bubbles is smaller and their size is larger for the higher annealing temperature. Also, for the higher annealing temperature the formation of delaminated regions already starts before SiNₓ deposition.

Experiments were performed wherein on a silicon substrate a stack comprising a thin ALD Al₂O₃ layer (thickness 5 nm, 10 nm and 30 nm) deposited at 200°C and a PECVD SiNₓ layer (thickness 200 nm to 300 nm) deposited at 420°C was provided. No separate annealing step was performed between the Al₂O₃ deposition and the SiNₓ deposition. It was observed that the formation of delaminated regions is influenced by the wafer cleaning used before the Al₂O₃ deposition. In case of a hydrophilic cleaning (resulting in a hydrophilic silicon surface), the size of the delaminated regions was found to be smaller than in case of a hydrophobic cleaning (resulting in a hydrophobic silicon surface). In the experiments, hydrophilic cleaning comprises cleaning in a sulfuric-peroxide mixture (H₂O₂:H₂SO₄ 1:4 at 85°C) followed by a 2% HF dip, cleaning in NH₄OH:H₂O₂:H₂O 1:1:5 at ambient temperature, and finally drying. Hydrophobic cleaning comprises cleaning in a sulfuric-peroxide mixture (H₂O₂:H₂SO₄ 1:4 at 85°C), followed by a 2% HF dip and drying. It was also observed that the size of the delaminated regions increases with increasing Al₂O₃ thickness. This is illustrated in Table 1, showing the size of the delaminated regions for the different cleanings and for different Al₂O₃ thicknesses.

**Table 1**

| | 5 nm Al₂O₃ | 10 nm Al₂O₃ | 30 nm Al₂O₃ |
|---|---|---|---|
| hydrophobic cleaning | 0 to 5 µm | 5 to 15 µm | 15 to 30 µm |
| hydrophilic cleaning | 0 to 0.5 µm | 0.5 to 1.5 µm | 1.5 to 3 µm |

Thus, it can be concluded that the size of the delaminated regions can be tuned by the surface pre-treatment, the ALD Al₂O₃ layer thickness and the post-deposition annealing conditions.

In one embodiment, the size (diameter) of the delaminated regions is preferably in the range between about 10 micrometer and 40 micrometer. The delaminated regions preferably cover about 2% to 5% of the total rear surface. Therefore it is preferred to perform a hydrophobic cleaning of the silicon surface before Al₂O₃ deposition. In certain embodiments the surface passivation layer is a stack comprising an Al₂O₃ layer with a thickness in the range between about 5 nm and 15 nm and a SiNₓ layer with a thickness of at least about 100 nm, the SiNₓ layer being deposited at a temperature in the range between about 400°C and 600°C such the need for a thermal treatment or annealing after Al₂O₃ deposition and before SiNₓ deposition can be avoided. In other embodiments the surface passivation layer can for example be an Al₂O₃ layer with a thickness of at least about 30 nm and a thermal treatment step is performed at a temperature in the range between about 400°C and 600°C after Al₂O₃ deposition, preferably in a nitrogen atmosphere.

Although the results described above are related to a passivation layer comprising an Al₂O₃ layer deposited by means of thermal ALD, similar bubble formation was found for Al₂O₃ layers deposited by other techniques, such as for example Plasma Enhanced ALD or Plasma Enhanced CVD. The bubbles appear due to stress build up in the Al₂O₃ layer (indicated by the behavior depending on thickness and temperature) and by hydrogen release in the Al₂O₃ layer upon thermal treatment.

Using a fabrication process in accordance with one embodiment, the number of process steps for photovoltaic cells with local back contact, e.g. PERC cells, can be reduced as compared to prior art methods. More in particular, the step of making openings in the rear side passivation layer before rear side metallization can be eliminated. As compared to a photovoltaic cell with a full A1 BSF, only one additional process step (depositing the surface passivation layer at the rear side) is needed for a gain in efficiency.

Experiments were performed wherein photovoltaic cells (size 148.25 cm²) were fabricated on p-type silicon substrates according to a method of one embodiment.

As a reference, p-type silicon photovoltaic cells with a full Back Surface Field (BSF), i.e. a BSF extending over the entire rear surface of the cells, were fabricated. For these reference cells, the front side of the substrate was textured and the rear side of the substrate was polished. An emitter was formed at the front side by POCl₃ diffusion, followed by deposition of a SiNₓ Antireflection coating (ARC) at the front side. Next an A1 layer was screen printed at the rear side and an Ag pattern was screen printed at the front side, followed by a metal co-firing step. The co-firing step results in the formation of an A1 BSF at the rear side of the cells. The current-voltage characteristics under AM1.5 illumination obtained for these reference cells are shown in Table 2.

**Table 2**

| | J_{sc} | V_{oc} | FF | Efficiency |
|---|---|---|---|---|
| | [mA/cm2] | [mV] | [%] | [%] |
| average 3 cells | 35.6 | 622.0 | 75.1 | 16.6 |
| best cell | 35.7 | 623.5 | 75.7 | 16.8 |

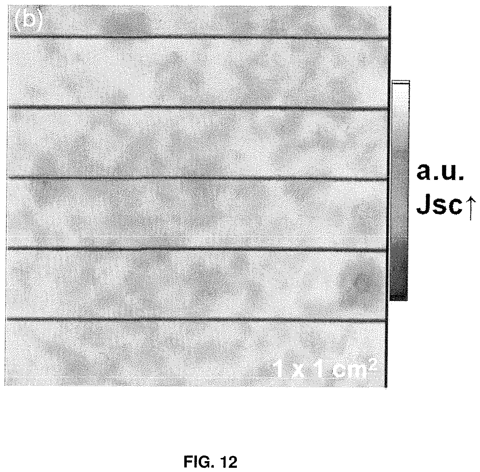

Photovoltaic cells were fabricated according to a method of one embodiment. The same process steps as used for fabricating the reference cells were used, except for one additional step. This additional step comprises depositing an Al₂O₃/SiNₓ passivation stack at the rear side of the cells, after the emitter diffusion and before the deposition of the antireflection coating. Before the deposition of the passivation stack a hydrophobic cleaning as described above was performed. In the experiments performed, the step of depositing a passivation stack comprised: depositing a first layer of ALD Al₂O₃ at about 200°C and depositing a second layer of PECVD SiN∗ at about 420°C on the first layer. The thickness of the Al₂O₃ layer was about 5 nm, 10 nm or 30 nm. The thickness of the SiNₓ layer was in the range between about 200 nm and 300 nm. Instead of screen printing the A1 layer at the rear side as for the reference cells, the A1 layer at the rear side was provided by sputtering. The A1 layer was provided over the entire rear surface of the cell, without making openings in the rear surface passivation stack. For the metal co-firing step, different temperatures were used: 845°C, 865°C and 885°C. At locations where the passivation stack is delaminated, local point contacts and a local BSF were formed after firing, as illustrated in the SEM cross section of Figure 7. Figure 12 shows a LBIC mapping of a random Al BSF solar cell part, clearly showing the random metal semiconductor contacts at the rear (20 µm as resolution).

The current-voltage characteristics under AM1.5 illumination obtained for these cells fabricated according to a method of one embodiment are shown in Table 3. From these results it can be concluded that, especially for the cells with the smallest Al₂O₃ layer thickness (about 5 nm) and for the cells with the largest Al₂O₃ layer thickness (about 30 nm) the Fill Factor is rather low. This may be related to non-optimal contacting at the rear side of the cells, for example related to a too low bubble density or to too small bubbles. In one embodiment, best results are obtained with an Al₂O₃ layer thickness of about 10 nm, showing higher short-circuit densities J_{sc} and higher open-circuit voltages V_{oc} as compared to the reference cells with a full BSF (Table 2) and with good Fill Factor values.

**Table 3**

| Metal co-firing at 845°C | | | | | |
|---|---|---|---|---|---|
| Al₂O₃ thickness | | J_{sc} | V_{oc} | FF | Efficiency |
| [nm] | | [mA/cm2] | [mV] | [%] | [%] |
| 5 | average | 29.5 | 634.8 | 40.5 | 7.6 |
| 5 | best cell | 29.5 | 634.8 | 40.5 | 7.6 |
| 10 | average | 36.5 | 629.5 | 72.3 | 16.6 |
| 10 | best cell | 36.9 | 630.3 | 72.5 | 16.8 |
| 30 | average | 36.1 | 636.3 | 63.9 | 14.7 |
| 30 | best cell | 37.3 | 634.7 | 66.7 | 15.8 |

| Metal co-firing at 865°C | | | | | |
|---|---|---|---|---|---|
| Al₂O₃ thickness | | J_{sc} | V_{oc} | FF | Efficiency |
| [nm] | | [mA/cm2] | [mV] | [%] | [%] |
| 5 | average | 37.4 | 632.1 | 70.2 | 16.6 |
| 5 | best cell | 37.4 | 632.1 | 70.2 | 16.6 |
| 10 | average | 36.9 | 627.9 | 74.8 | 17.3 |
| 10 | best cell | 36.9 | 626.3 | 75.4 | 17.4 |
| 30 | average | 37.1 | 635.6 | 69.1 | 16.3 |
| 30 | best cell | 37.1 | 636.3 | 71.0 | 16.7 |

| Metal co-firing at 885°C | | | | | |
|---|---|---|---|---|---|
| Al₂O₃ thickness | | J_{sc} | V_{oc} | FF | Efficiency |
| [nm] | | [mA/cm2] | [mV] | [%] | [%] |
| 5 | average | 36.3 | 618.7 | 73.6 | 16.6 |
| 5 | best cell | 36.6 | 619.9 | 73.6 | 16.7 |
| 10 | average | 36.5 | 623.7 | 74.6 | 17.0 |
| 10 | best cell | 36.2 | 624.4 | 75.2 | 17.0 |
| 30 | average | 36.6 | 633.5 | 67.9 | 15.8 |
| 30 | best cell | 37.1 | 632.2 | 71.1 | 16.7 |

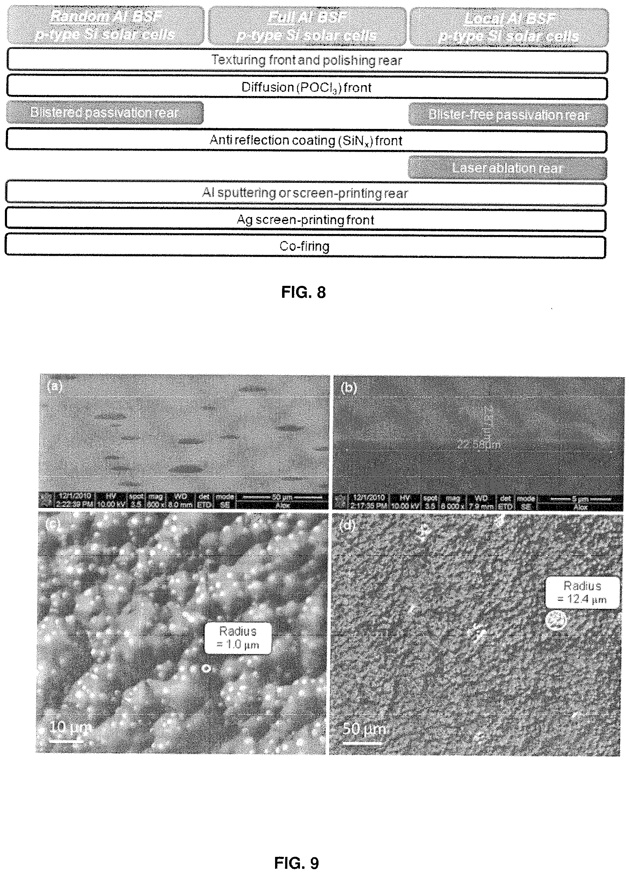

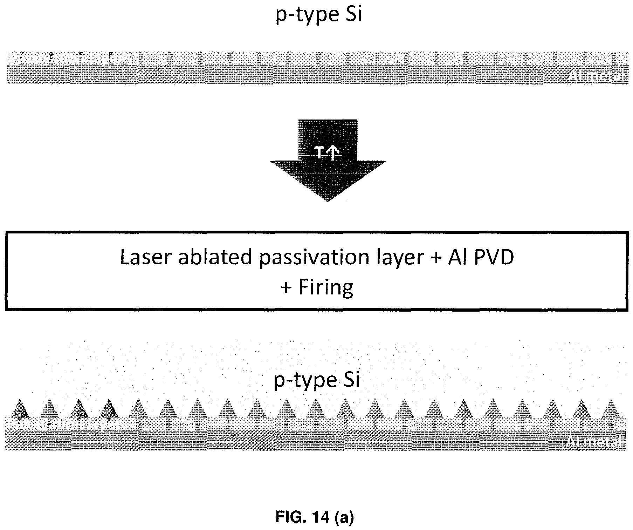

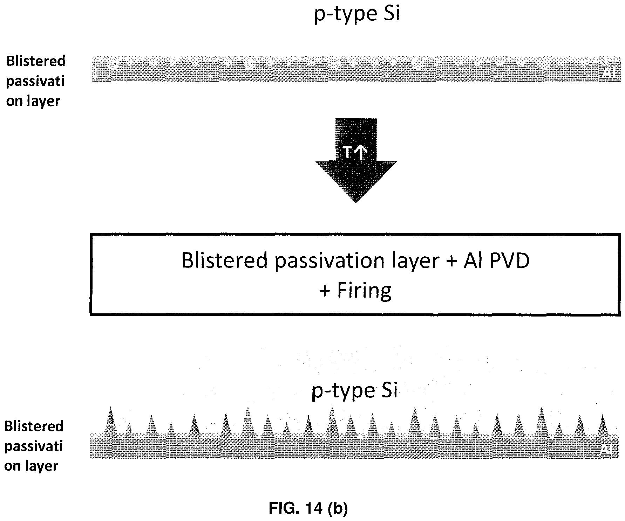

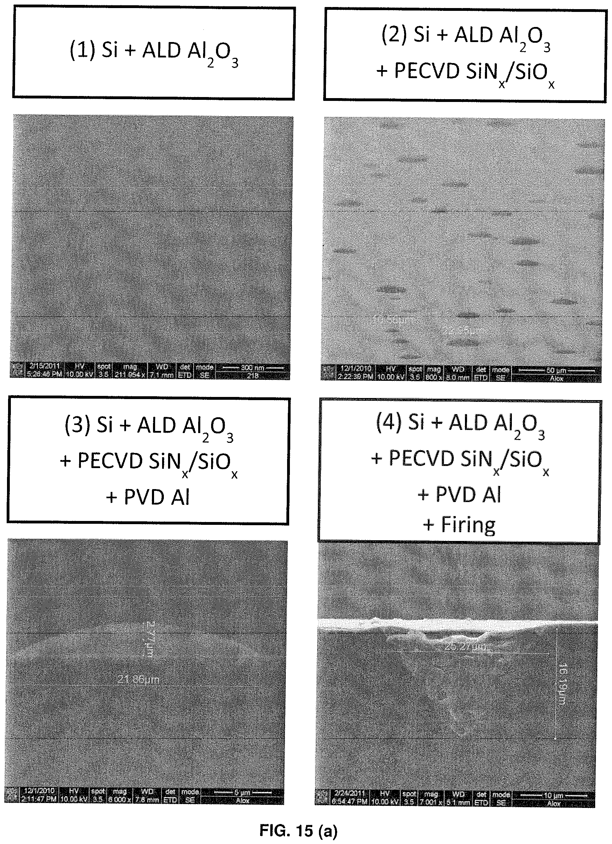

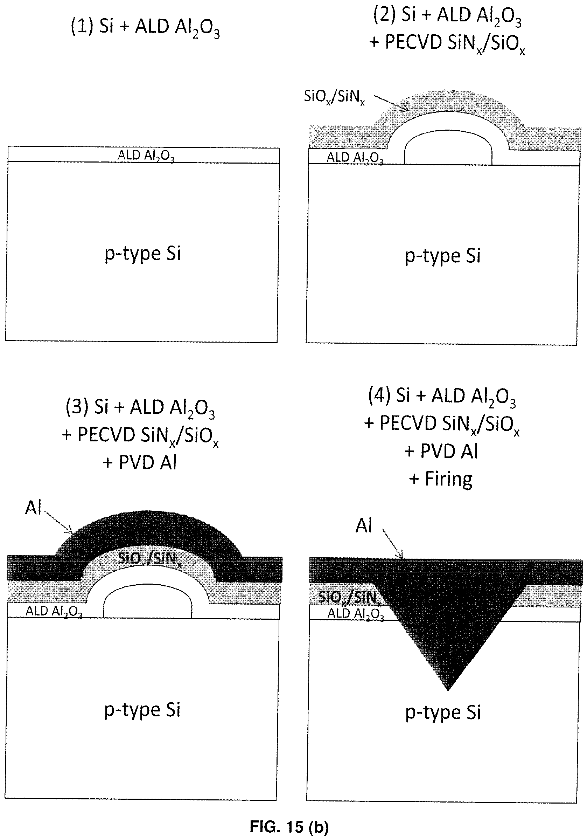

In Figure 8, baseline random A1 BSF (left), full A1 BSF reference (middle) and local A1 BSF (right) p-type Si solar cell process sequences are depicted. Figure 14 (a) further illustrates a process with laser ablated passivation layer with local A1 BSF. Figure 14(b) further illustrates the random A1 BSF with the blistered passivation layer. Also Figures 15 (a) and (b) illustrate a process flow according to embodiments of the present invention wherein contacts are formed by means of blisters in the passivation layer. Flow (a) comprises images of real samples, while flow (b) is a schematic representation of the same flow.

Further results will be described now, which may partially overlap with any of the above mentioned results.

In the experiments, the cells had a surface of 148.25 cm² and were 150 µm thick, and had a base resistivity of 2 Ω.cm and an emitter of 60 Ω/sq.

In the case of random local A1 BSF cells, a blistered layer was used as rear surface passivation without any additional contact opening step. Full and blister-free local A1 BSF cells are used as references.

Pre-passivation Si wafer cleanings have an HF-last (Si-H) or oxidizing (Si-OH) last step and finish with Marangoni drying, known to the skilled person.

As rear surface passivation for the random and local A1 BSF cells, a stack of ALD A12O3 and PECVD SiNx was used. Thermal ALD A12O3 films of 5, 10 or 30 nm thickness were grown at 200 °C in a commercial ALD reactor using trimethylaluminium (TMA) and de-ionized (DI) water as precursors. The SiNx layer thickness was optimized for the rear internal reflectance in the solar cells. The co-firing process step has been performed at 845, 865 or 885 °C for random and 865 °C for local and full A1 BSF cells.

Blistering is visualized and measured with a scanning electron microscope (SEM) or optical microscope. The used current-voltage (I-V) setup is a steady-state Xe lamp solar simulator with an illuminated area of 200 x 200 mm2, a small bias error and a good stability over time. Spatially resolved series resistance of silicon solar cells is measured using a commercial photoluminescence (PL) system. An in-house assembled Light Beam Induced Current (LBIC) measurement setup is used to map the short circuit current (Jsc) of solar cells at a wavelength of 1050 nm.

### Results and discussion:

Blistering in ALD A12O3 / PECVD SiNx passivation layers occurred. Blistering is the partial delamination of a thick enough (for instance larger than or equal to 10 nm) A12O3 layer caused by gaseous desorption in the A12O3 film upon thermal treatments above a critical temperature: the A12O3 layer acts as a gas barrier and bubble formation occurs. Capping A12O3 with SiOx or SiNx also shows blistering: the capping layer is deposited at temperatures above this critical temperature and the total stack is a more efficient gas barrier. SEM pictures of typical blistered A12O3 / SiNx stacks deposited on Si are shown in figures 9 (a) and (b).

The pre-ALD cleaning matters, as hydrophilic cleaning leads to a large density of small blisters, while hydrophobic cleaning leads to a smaller density of larger blisters, as can be seen in figures 9 (c) and (d), respectively.

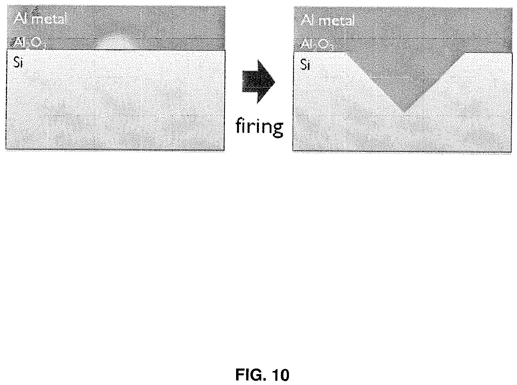

It is shown that during co-firing local A1 BSFs can be induced at the location of blisters, as sketched in figure 10.

Using a thin enough Al2O3 layer and performing an annealing step e.g. at a temperature above 600 °C prior to SiNx capping can be performed to avoid blistering: the Al2O3 is out-gassed prior to SiNx capping and can still have adequate passivation properties. This has been done to prepare the blister free local A1 BSF reference cells where laser ablation was used to open the rear dielectric prior to metallization.

### Random Al BSF Si solar cells with a blistered layer as rear surface passivation.

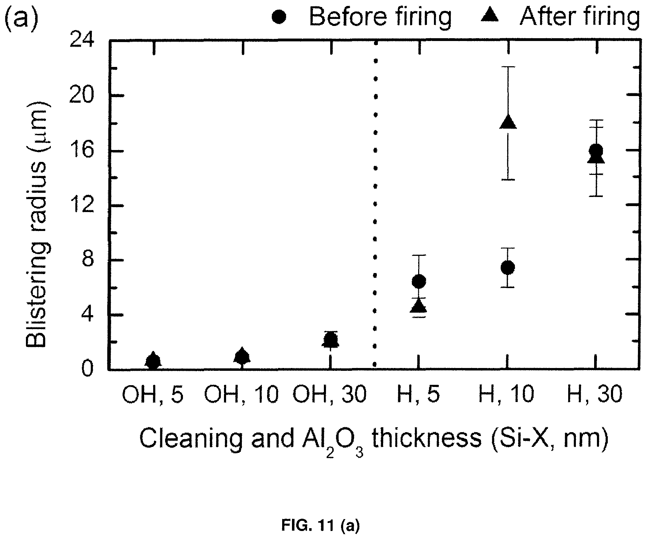

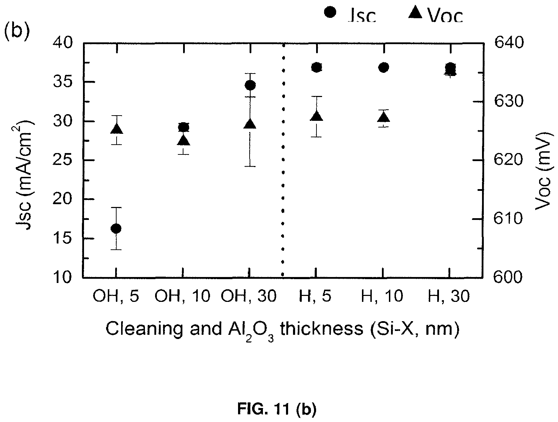

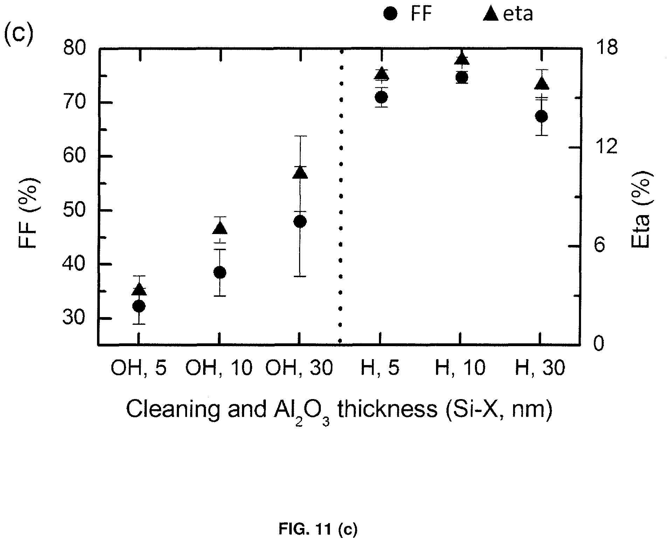

Random A1 BSF solar cells were completed where a stack of Al2O3 and SiNx is used as blistered rear surface passivation. As well hydrophilic and hydrophobic pre-ALD cleaning and 5, 10 or 30 nm of Al2O3 have been used, in this way the average size and density of the blisters in the Al2O3 / SiNx are varied as shown in figure 11 (a). This average size and density was measured before and after the co-firing step. After the firing, the rear A1 metal layer of the random A1 BSF cells was removed in hot HCl to revisualize the blistering. Also the averages of Jsc, open circuit voltage (Voc), fill factor (FF) and conversion efficiency (Eta) for the random local A1 BSF cells fired at 865 °C is given in figures 11 (b) and 11 (c).

From figure 11 (a,b,c) it is obvious that a minimum blistering size (preferably in the range of 4 to 100 micrometer, more preferably in the range of 5 to 50 micrometer, even more preferably in the range of 10 to 30 micrometer) is advantageous to enable enough contacting and consequently a high enough FF and Jsc. Even more, the best FF and Jsc are obtained when the blistering size still increases during firing, which is the case for a 10 nm Al2O3 and a hydrophobic pre-ALD cleaning. The hydrophilic pre-ALD cleaning is less favorable since the blistering size is too low and the density too high, as already seen in figure 9 and reflected in a lower FF, Jsc and even Voc. On the other hand a thickness of 10 nm for the Al2O3 (a thickness for instance in the range of 5 nm to 20 nm, more preferably 7nm to 15 nm) is favorable since it is not too thick to cause blistering on itself (as compared to 30 nm A1203) and it is thick enough to allow sufficient additional out-gassing during the firing (as compared to 5 nm Al2O3). SEM measurements clearly prove that local BFSs are created upon firing of a blistered rear passivation layer covered by metal, see figure 7. On the other hand, LBIC measurements illustrate the random distribution of these local contacts as darker regions where the Jsc is reduced, see figure 12.

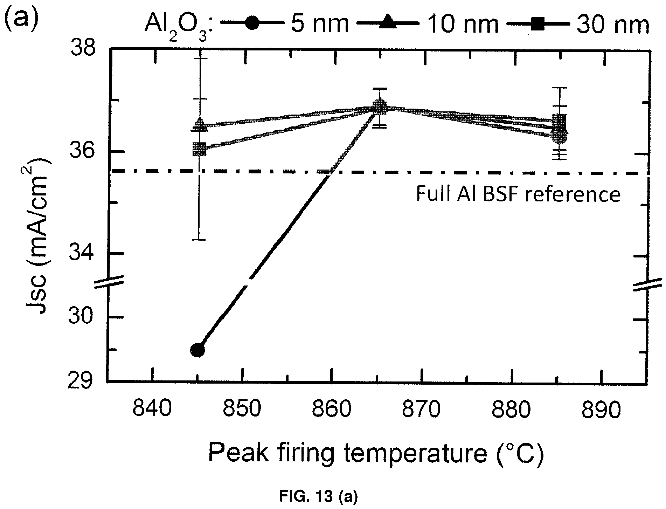

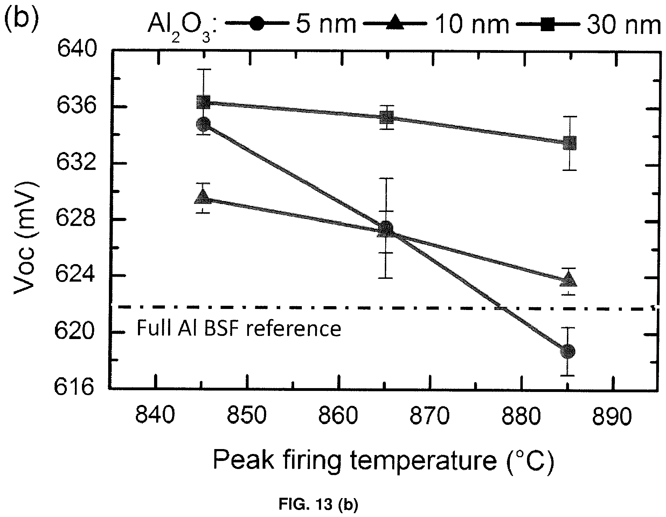

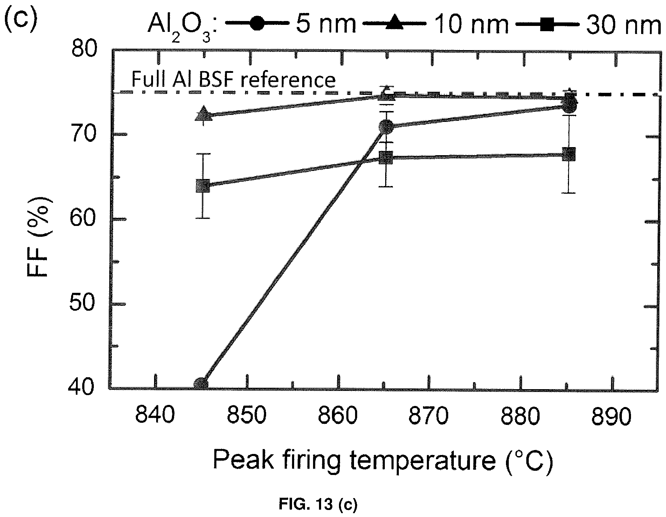

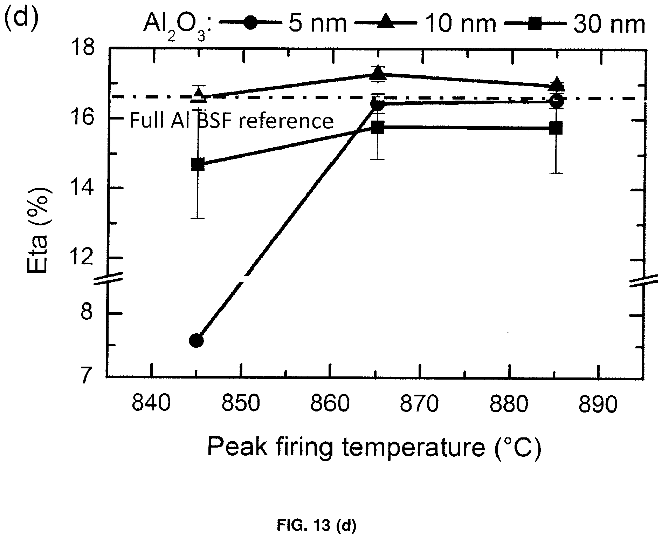

For hydrophobic cleaned random A1 BSF cells prior to ALD the blistering size is large enough to enable sufficient contacting, therefore the average Jsc, Voc, FF and Eta as a function of peak firing temperature are shown in figure 13 (a,b,c,d). It is clear that there is a balance between passivation and contacting as a function of peak firing temperature. If the firing temperature is too high, the rear surface passivation or Voc may decrease too much. On the other hand, if the peak firing temperature is too low, the rear contacting or FF (and hence Jsc) may not be optimal.

The best random A1 BSF cells have an average cell efficiency of 17.4 % compared to 16.6 % for full A1 BSF reference cells. There is an apparent gain in Jsc and Voc of 1.3 mA/cm2 and 5 mV respectively, because of better rear internal reflection and rear surface passivation. In a separate experiment, also blister-free local A1 BSF cells have been prepared; indicating that potentially a gain in Voc of 14.2 mV should be achievable for the random A1 BSF cells compared to full Al BSF cells. This gap in Voc between the best Al2O3 / SiNx passivated random and local A1 BSF cells has two reasons. In the case of the hydrophobic pre-ALD cleaning: during firing a large density of smaller blisters is created. This additional layer of blisters might lead or lead not to additional contacting but will cause a lower Voc in both cases. The blistering density is not at all uniform and clearly lower at the edges of a Si wafer. This leads to an increased cell series resistance at the edge of random A1 BSF cells compared to full A1 BSF cells. The additional layer of tiny blisters can be avoided by an annealing step between the Al2O3 and SiNx deposition. An annealing step is preferably performed at a temperature that is sufficiently high (e.g. higher than 600°C) to outgas the Al2O3 film just enough to avoid the creation of this additional layer of small blisters during firing. However this annealing step should be performed at a temperature that is low enough (e.g. lower than 900°C, preferably lower than 800°C) to leave the opportunity of a minor size increase during firing for the already existing blisters. By comparing the formation of blisters on mirror polished wafers to textured wafers, it was observed that blisters appear easier in the vicinity of surface features. This effect can be used to compensate the lower blistering density at the edge of wafers.

The foregoing description details certain embodiments of the invention. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to including any specific characteristics of the features or aspects of the invention with which that terminology is associated.

While the above detailed description has shown, described, and pointed out novel features of the invention as applied to various embodiments, it will be understood that various omissions, substitutions, and changes in the form and details of the device or process illustrated may be made by those skilled in the technology without departing from the spirit of the invention.

## Claims

1. A method for fabricating a photovoltaic cell comprising local back contacts, comprising:
- providing a silicon substrate;
- depositing a surface passivation layer at a rear side of the silicon substrate;
- forming delaminated regions at an interface between the surface passivation layer and the silicon substrate;
- depositing a metal layer on the surface passivation layer; and performing a metal firing step.

2. Method according to claim 1, wherein forming delaminated regions at an interface between the surface passivation layer and the silicon substrate comprises:
cleaning the silicon substrate using a hydrophobic cleaning method;
depositing said surface passivation layer at a rear side of the silicon substrate after hydrophobic cleaning;
performing a thermal treatment.

3. Method according to claim 2, wherein depositing a surface passivation layer comprises depositing a surface passivation layer having a thickness of at least about 30 nm.

4. Method according to claim 2 or 3, wherein performing a thermal treatment comprises performing a temperature treatment at a temperature in the range between about 400°C and 600°C.

5. Method according to any of claims 2 to 4, wherein said hydrophobic cleaning method comprises a cleaning method leaving a hydrophobic surface after cleaning.

6. Method according to any of the previous claims, wherein depositing said surface passivation layer comprises depositing a stack of layers.

7. Method according to claim 6, wherein said surface passivation layer comprises a first layer comprising Al₂O₃, with a thickness in the range between about 2 nm and 30 nm, and a second layer comprising a SiNₓ layer and/or a SiOₓ layer, with a thickness in the range between about 70 nm and 300 nm.

8. Method according to claim 7, wherein said first layer is deposited at a temperature lower than 250 °C and the second layer is deposited at a temperature in the range between about 400°C and 600°C, thereby at the same time performing said thermal treatment.

9. Method according to any of the previous claims, wherein said metal comprises Aluminum and wherein said metal firing step is performed at a temperature in the range between about 835°C and 950°C.

10. Method according to any of the claims 7 to 9, further comprising performing an additional anneal step after depositing said first layer and before depositing said second layer, said additional anneal step being done at a temperature within the range of 600 °C and 900 °C.

11. Use of the method according to any of the previous claims, for forming local back contacts of said photovoltaic cells at the location of said delaminated regions.

12. A photovoltaic device having a rear surface and a front surface, comprising
a. a silicon substrate;
b. a surface passivation layer at a rear side of the silicon substrate;
c. local back contacts;
wherein said local back contacts are randomly distributed on said rear surface of said photovoltaic device.

13. A photovoltaic device according to claim 12, wherein said passivation layer comprises delaminated regions at positions corresponding to said local back contacts.

14. A photovoltaic device according to any of claims 12 or 13, wherein said passivation layer has a thickness of at least 30 nm.

15. A photovoltaic device according to claim 14, wherein said passivation layer comprises a first layer comprising Al₂O₃, with a thickness in the range between about 2 nm and 30 nm, and a second layer comprising a SiNₓ layer and/or a SiOₓ layer, with a thickness in the range between about 70 nm and 300 nm.
